# EUROPEAN PATENT APPLICATION

(11) **EP 4 592 702 A1**
(43) Date of publication of application: **30.07.2025**
(21) Application number: 22961106.6
(22) Date of filing: 25.10.2022
(51) Int. Cl.: G01S 7/35, G01S 13/34, G01S 7/04

(54) **FREQUENCY MODULATED CONTINUOUS WAVE RADAR SENSOR, AND ELECTRONIC DEVICE COMPRISING SAME**

(30) Priority: 27.09.2022 KR 20220122364
(71) Applicant: LG Electronics Inc., Yeongdeungpo-gu Seoul 07336 (KR)
(72) Inventor: JEONG, Chihwan, Seoul 06772 (KR); CHO, Sanghyeok, Seoul 06772 (KR); KIM, Seonghyok, Seoul 06772 (KR); KIM, Sanggyu, Seoul 06772 (KR)
(74) Representative: Frenkel, Matthias Alexander
(86) International application number: PCT/KR2022/016387
(87) International publication number: WO 2024/071507

(57) **Abstract**

A frequency modulated continuous wave radar sensor according to an embodiment of the present invention may comprise: a signal generator for generating frequency modulated (FM) signals that change frequency over time; a transmission antenna for transmitting the FM signals generated by the signal generator; a reception antenna for receiving reflected signals of the FM signals reflected by an object; a frequency mixer which outputs the difference between the FM signals and the reflected signals; and a filter which extracts a mid-frequency component from the output of the frequency mixer.

## Description

### [Technical Field]

The present disclosure relates to a frequency modulated continuous wave radar sensor and an electronic device including the same.

### [Background Art]

Frequency modulated continuous wave radar sensor is a sensor that detects a distance between a radar and a sensor by a frequency difference between a transmitted electromagnetic wave whose frequency changes over time and a received electromagnetic wave that is reflected back by an object.

Since this sensor can detect the presence, distance, and location of an object, it is used in various fields such as home appliances, industry, automobiles, and military.

However, there is a limitation in that it cannot detect the state of an object. In addition, conventional measuring equipment that can detect the state of an object requires high-speed sampling, which requires expensive parts/equipment.

### [Disclosure]

### [Technical Problem]

A purpose of the present disclosure is to provide a frequency modulated continuous wave radar sensor capable of obtaining a distance to an object and characteristics of the object, and an electronic device including the same.

The purpose of the present disclosure is to provide a frequency modulated continuous wave radar sensor capable of obtaining characteristic information of an object in real time without contact using a frequency characteristic signal, and an electronic device including the same.

### [Technical Solution]

A frequency modulated continuous wave radar sensor according to an embodiment of the present disclosure comprises a signal generator configured to generate a Frequency Modulated (FM) signal whose frequency changes over time, a transmitting antenna configured to transmit the FM signal generated by the signal generator, a receiving antenna configured to receive a reflected signal of an FM signal reflected from an object, a frequency mixer configured to output a difference between the FM signal and the reflected signal, and a filter configured to extract an intermediate frequency component from an output of the frequency mixer.

The frequency modulated continuous wave radar sensor can further comprises an extractor configured to obtain an envelope of the extracted intermediate frequency component.

The extractor can obtain the envelope by demodulating or Hilbert transforming the extracted intermediate frequency component.

An electronic device according to an embodiment of the present disclosure comprises a receiving part in which a space for receiving an object is formed, a frequency modulated continuous wave radar sensor configured to detect characteristics of the object, and a controller, wherein the frequency modulated continuous wave radar sensor comprises a signal generator configured to generate a Frequency Modulated (FM) signal whose frequency changes over time, a transmitting antenna configured to transmit the FM signal generated by the signal generator, a receiving antenna configured to receive a reflected signal of an FM signal reflected from an object, a frequency mixer configured to output a difference between the FM signal and the reflected signal, and a filter configured to extract an intermediate frequency component from an output of the frequency mixer, wherein the controller is configured to acquire characteristics of the object using the extracted intermediate frequency component.

The electronic device can further comprise a memory configured to store data that maps envelope waveforms of each type of object, wherein the controller can obtain a type of object having a waveform similar to the envelope obtained by the extractor from the memory.

The electronic device can further comprise a display outputting the obtained object.

The data can include a plurality of envelope waveforms for each type of object according to state of each object.

The controller can obtain a type and state of objects accommodated in the space.

An operating method of a frequency modulated continuous wave radar sensor according to an embodiment of the present disclosure comprises generating a Frequency Modulated (FM) signal whose frequency changes over time, transmitting the FM signal generated by a signal generator, receiving a reflected signal in which the FM signal is reflected from an object, outputting a difference between the FM signal and the reflected signal, and extracting an intermediate frequency component from an output of the frequency mixer.

The operating method of a frequency modulated continuous wave radar sensor can further comprise obtaining an envelope of the extracted intermediate frequency component.

An operating method of an electronic device according to an embodiment of the present disclosure comprises generating a Frequency Modulated (FM) signal whose frequency changes over time, transmitting the FM signal generated by a signal generator, receiving a reflected signal in which the FM signal is reflected from an object, outputting a difference between the FM signal and the reflected signal, extracting an intermediate frequency component from an output of the frequency mixer, and obtaining characteristics of the object using the extracted intermediate frequency component.

The operating method of an electronic device can further comprise obtaining an envelope of the extracted intermediate frequency component, and the obtaining of the characteristics of the object can include obtaining the characteristics of the object using the envelope.

The operating method of an electronic device can further comprise displaying the characteristics of the object.

### [Advantageous Effects]

According to an embodiment of the present disclosure, there is an advantage in that a frequency-modulated continuous wave radar sensor capable of obtaining not only the distance of an object but also its characteristics using only an intermediate frequency component can be provided, while being implemented in a compact and low-cost manner.

According to an embodiment of the present disclosure, there is an advantage in that the internal state of an object can be detected using a frequency-modulated continuous wave radar sensor capable of obtaining the characteristics of the object.

According to an embodiment of the present disclosure, there is an advantage in that the management efficiency of objects provided inside is improved through an electronic device including a frequency-modulated continuous wave radar sensor capable of obtaining not only the distance of an object but also its characteristics.

### [Description of Drawings]

Fig. 1 describes a method for a conventional measuring device to measure the characteristics of an object using a continuous wave.
Fig. 2 describes a method for a conventional frequency modulated continuous wave radar sensor to measure a distance to an object.
Fig. 3 is a block diagram of a frequency modulated continuous wave radar sensor according to an embodiment of the present disclosure.
Fig. 4 is a block diagram of a frequency modulated continuous wave radar sensor according to another embodiment of the present disclosure.
Fig. 5 is an exemplary diagram for explaining signal waveforms that have passed through each of the filter and extractor in Fig. 3 or Fig. 4.
Fig. 6 is a diagram illustrating an electronic device including a frequency modulated continuous wave radar sensor according to an embodiment of the present disclosure.
Fig. 7 is a control block diagram of an electronic device including a frequency modulated continuous wave radar sensor according to an embodiment of the present disclosure.
Fig. 8 is an exemplary diagram illustrating envelope waveforms for each type of object.
Fig. 9 is an example diagram showing an envelope waveform that changes depending on the state of an object.
Fig. 10 is a flowchart showing an operation method of an electronic device according to an embodiment of the present disclosure.
Fig. 11 is a flowchart illustrating a method in which an electronic device operates by communicating with a server and a smartphone according to an embodiment of the present disclosure.

### [Best Mode]

Hereinafter, a preferred embodiment according to the present disclosure will be described in detail with reference to the attached drawings. In the drawings, the same reference numerals are used to indicate the same or similar components.

The suffixes "module" and "part" used for components in the following description are given or used interchangeably only for the convenience of writing the specification, and do not have distinct meanings or roles in themselves.

In the following description, "connected" between components includes not only direct connection of the components, but also indirect connection through at least one other component, unless otherwise specified.

Below, a frequency modulated continuous wave radar sensor capable of obtaining the distance to an object as well as the characteristics of the object and an electronic device including the same are described.

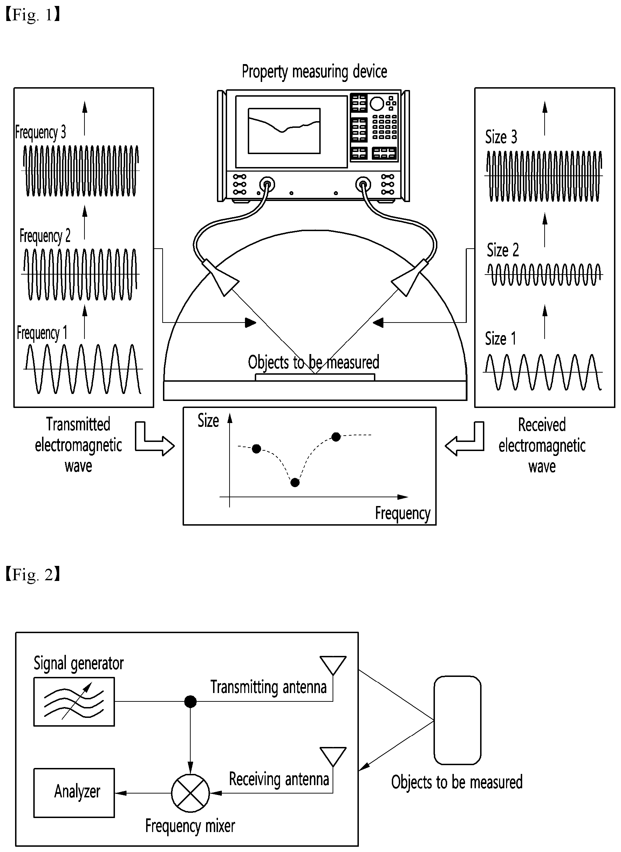

Fig. 1 describes a method for a conventional measuring device to measure the characteristics of an object using a continuous wave.

A conventional measuring device transmitted electromagnetic waves to an object while changing the frequency. For example, as indicated by Frequency 1, Frequency 2, Frequency 3, ... in the Transmitted electromagnetic wave, the electromagnetic wave was transmitted to the object while increasing the frequency. And, by measuring the signal size of the received electromagnetic wave that is reflected back from the object by the transmitted electromagnetic wave, the electrical frequency response characteristics of the object being measured were measured.

However, in this case, the received electromagnetic wave has the same frequency as the transmitted electromagnetic wave (several GHz or more), so high-speed sampling is required for digitization, which requires expensive parts/equipment. In addition, there is a disadvantage in that the measurement time is long because the method of measuring one point at a time is used.

Fig. 2 describes how a conventional frequency modulated continuous wave radar sensor measures the distance to an object.

A conventional frequency modulated continuous wave laser sensor transmits a chirp-shaped electromagnetic wave, the frequency of which increases over time, generated by a signal generator, through a transmitting antenna, and receives a received electromagnetic wave that is reflected by an object to be measured and returned through a receiving antenna. A frequency mixer passes the transmitted electromagnetic wave and the received electromagnetic wave to obtain the difference between them, and the analyzer can measure the distance to the object based on the difference.

However, the conventional frequency modulated continuous wave radar sensor has a limitation in that it is difficult to identify the characteristics of an object, and the present disclosure aims to provide a frequency modulated continuous wave radar sensor capable of measuring both the distance to an object and the characteristics of the object.

Hereinafter, a frequency modulated continuous wave radar sensor according to an embodiment of the present disclosure will be described.

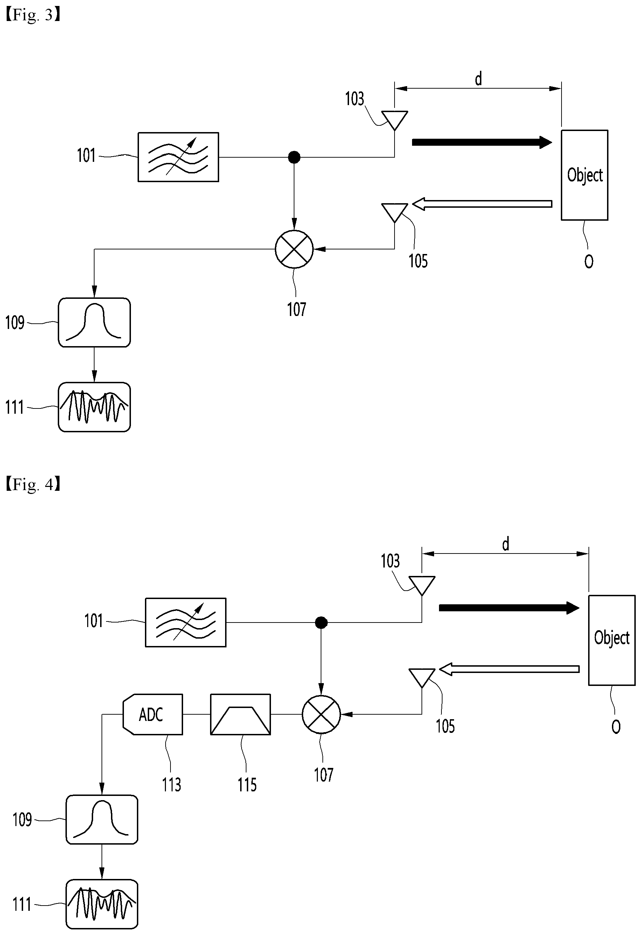

Fig. 3 is a block diagram of a frequency modulated continuous wave radar sensor according to an embodiment of the present disclosure.

A frequency modulated continuous wave radar sensor according to an embodiment of the present disclosure may include at least some or all of a signal generator 101, a transmitting antenna 103, a receiving antenna 105, a frequency mixer 107, a filter 109, and an extractor 111.

The signal generator 101 can generate an FM (Frequency Modulated) signal whose frequency increases over time. The signal generated by the signal generator 101 can have a chirp waveform. The signal generator 101 can be a Chirp-Transmitter. The signal generator 101 can be a signal generating device.

The transmitting antenna 103 can transmit the FM signal generated by the signal generator 101. The FM signal transmitted by the transmitting antenna 103 can reach the object O. The FM signal reaching the object O can be reflected and returned.

The receiving antenna 105 can receive a reflected signal of an FM signal reflected from the object O.

The frequency mixer 107 can output the difference between the FM signal generated by the signal generator 101 and the reflected signal.

The filter 109 can extract intermediate frequency (IF) components from an output of the frequency mixer 107. The filter 109 may be a band pass filter that extracts only a specific frequency range.

The Intermediate frequency (IF) is a frequency between radio frequency (RF) and baseband frequency. A frequency modulated continuous wave radar sensor according to an embodiment of the present disclosure can obtain a distance to an object using the extracted intermediate frequency component. Since the intermediate frequency can obtain a digital signal even with low-speed sampling, it is implemented to obtain the distance and characteristics from an object by extracting the intermediate frequency component, thereby enabling miniaturization and reduction of manufacturing costs.

The extractor 111 can obtain an envelope of the intermediate frequency component extracted by the filter 109. For example, the extractor 111 can obtain the envelope of the intermediate frequency component extracted by demodulation or Hilbert Transform, but this is only an example and is not limited thereto.

The frequency modulated continuous wave radar sensor according to an embodiment of the present disclosure can obtain the characteristics of an object using the envelope. In particular, since it is a characteristic detection through a change in electromagnetic waves reflected from an object and returned, there is an advantage in that the internal characteristics of an object that cannot be recognized by the naked eye or a camera can be detected through the envelope. Specifically, there is an advantage in that the characteristics of an object can be obtained by utilizing the fact that the envelope appears differently depending on the material and characteristics, even if the size and shape are the same.

Although not shown in Fig. 3, the frequency modulated continuous wave radar sensor according to an embodiment of the present disclosure may further include an analyzer (not shown) for obtaining the distance to the object using the intermediate frequency component extracted by the filter 109 and obtaining the characteristics of the object using the envelope extracted by the extractor 111. In addition, the frequency modulated continuous wave radar sensor may further include a memory (not shown) in which example data of reference envelope waveforms according to materials and characteristics for analyzing the characteristics of the object are stored.

In addition, the frequency modulated continuous wave radar sensor according to the embodiment of the present disclosure may further include a baseband filter and an analog-to-digital converter.

Fig. 4 is a block diagram of a frequency modulated continuous wave radar sensor according to another embodiment of the present disclosure.

As illustrated in Fig. 4, the frequency modulated continuous wave radar sensor may include at least some or all of a signal generator 101, a transmitting antenna 103, a receiving antenna 105, a frequency mixer 107, a filter 109, an extractor 111, an analog-to-digital converter 113, and a second filter 115.

The analog-to-digital converter 113 can convert an analog signal that has passed through the second filter 115 into a digital signal.

The second filter 115 can pass only a specific band from the output of the frequency mixer 107. The second filter 115 may be a low pass filter, but this is only an example, and it is reasonable that it is not limited thereto. As it passes through the second filter 115, noise is removed, and there is an advantage that the accuracy of distance and characteristic measurements with respect to an object is improved.

In addition, the remaining configurations are the same as those described in Fig. 3, so redundant descriptions will be omitted.

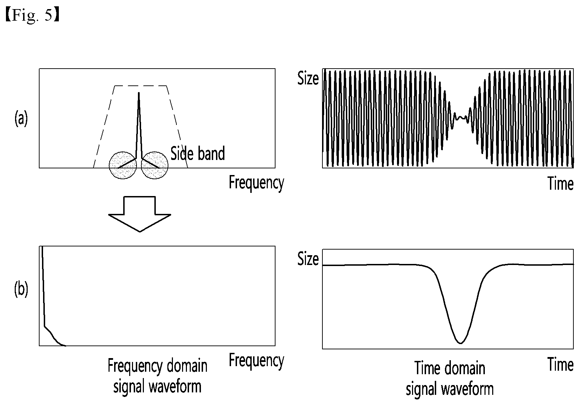

Fig. 5 is an example diagram for explaining signal waveforms that have passed through each of the filter and the extractor in Fig. 3 or Fig. 4.

In Fig. 5, the left side shows a signal waveform in the frequency domain, and the right side shows a signal waveform in the time domain.

Fig. 5 (a) is an example of a signal waveform that has passed through the filter 109, and may include only the intermediate frequency component. In addition, the signal filtered with the intermediate frequency component may include distance information between the frequency modulated continuous wave radar sensor and the object O.

In addition, the side-band of the frequency domain signal shown on the left side of Fig. 5 (a) includes envelope information.

Fig. 5 (b) shows an envelope waveform extracted from a signal extracted from the filter 109. The characteristics of the object may be extracted according to the envelope waveform.

The characteristics of the object may include permittivity, permeability, etc., but since this is only an example, it is reasonable that it is not limited thereto.

The above-described frequency modulated continuous wave radar sensor may be equipped and used in various electronic devices. For example, a modulated continuous wave radar sensor can be included in various home appliances such as a refrigerator, a microwave oven, and an air fryer, but this is only an example and it is reasonable that it is not limited thereto.

Hereinafter, the operating method when the frequency modulated continuous wave radar sensor is installed in an electronic device is described. In particular, for the convenience of explanation, it is assumed that a frequency modulated continuous wave radar sensor is installed in a refrigerator.

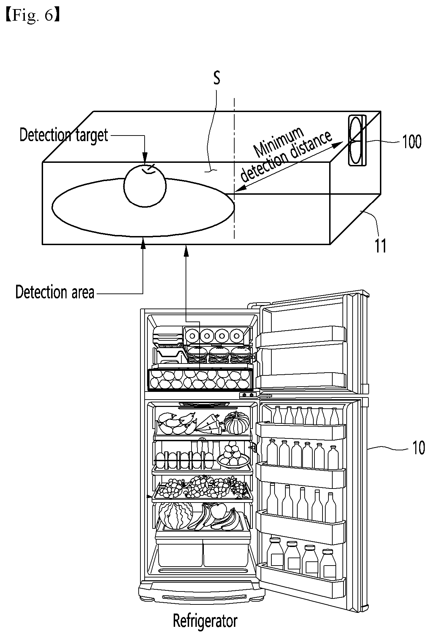

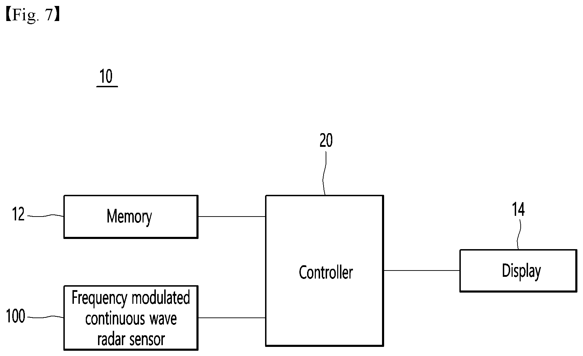

Fig. 6 is a drawing showing an electronic device including a frequency modulated continuous wave radar sensor according to an embodiment of the present disclosure, and Fig. 7 is a control block diagram of an electronic device including a frequency modulated continuous wave radar sensor according to an embodiment of the present disclosure.

The electronic device 10 may include a receiving part 11 in which a space S in which an object is accommodated is formed, a memory 12, a display 14, a controller 20, and a frequency modulated continuous wave radar sensor 100 that detects a characteristic of the object.

The receiving part 11 may be a space in which an object is accommodated. For example, if the electronic device 10 is a refrigerator, the receiving part 11 may be a storage room for storing food. The frequency modulated continuous wave radar sensor 100 may be installed in the receiving part 11, but the location may be changed. However, a predetermined distance from the detection target may be required for accurate detection of the detection target. The detection area may vary depending on the installation location of the frequency modulated continuous wave radar sensor 100.

The display 14 can display the characteristics of the object. That is, display 14 can display the type and state of the object.

The memory 12 can store data that maps the envelope waveform of each type of object. If the electronic device 10 is a refrigerator, the types of objects can be various, such as apples, pears, tangerines, pork, beef, lettuce, perilla leaves, mackerel, tuna, and dumplings. That is, the memory 12 can store data that maps the envelope waveform corresponding to apples, the envelope waveform corresponding to pears, the envelope waveform corresponding to tangerines, the envelope waveform corresponding to pork, ... That is, the memory 12 can store data that maps the envelope waveform of each of various food materials and foods.

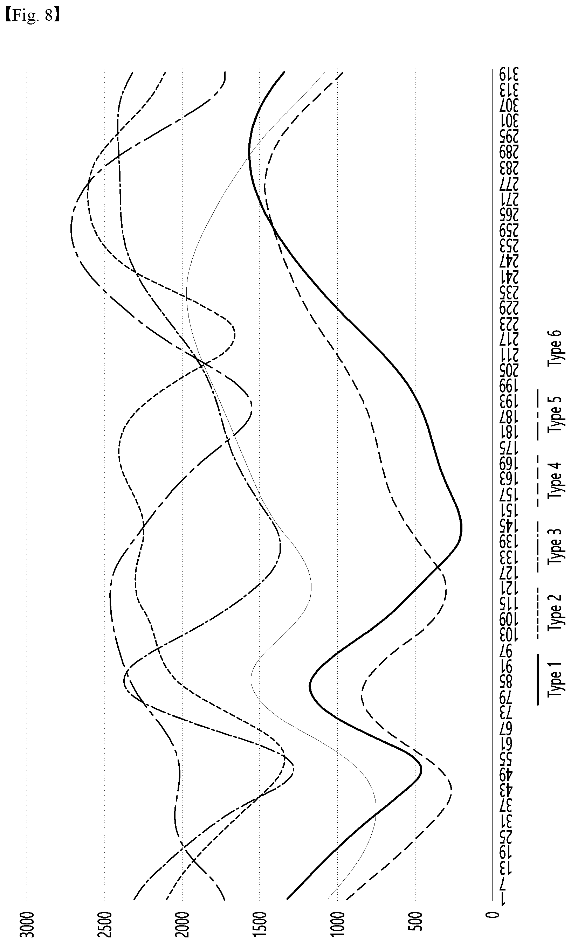

Fig. 8 is an example drawing showing the envelope waveform by type of object.

Fig. 8 shows the envelope waveform by type of object that has the same shape and size but different materials, etc. This is actually a waveform measured by making the electromagnetic wave incident angle 0 degrees for objects of different materials, and the thick line represents the average value and the thin line represents the deviation between measurements.

As in the example of Fig. 8, it can be confirmed that the envelope waveform is different by type of object.

Therefore, the controller 20 can obtain the type of object based on the waveform of the object.

In addition, even for the same object, the envelope waveform may vary depending on the state. Specifically, food materials, food, etc. may change in state as they deteriorate over time, and the envelope waveform may also vary accordingly.

In this specification, the characteristics of an object may include the type and state of the object.

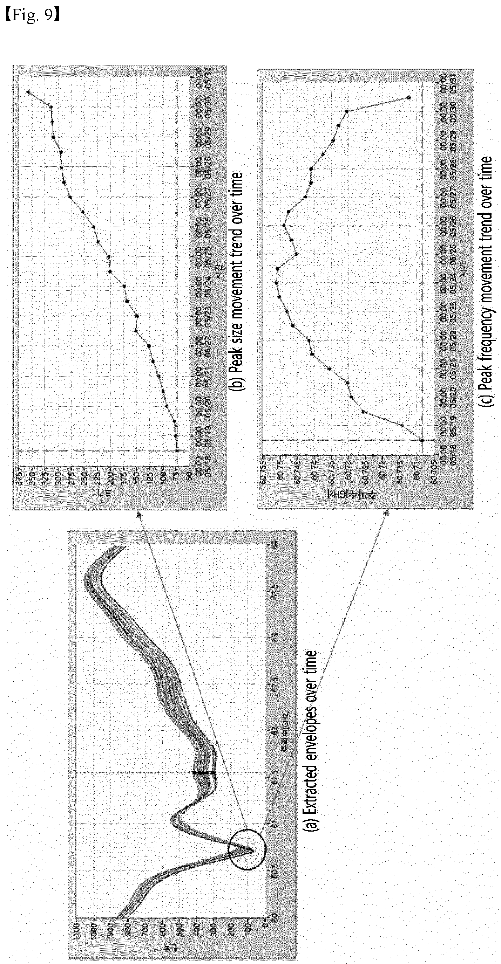

Fig. 9 is an example diagram showing an envelope waveform that changes depending on the state of an object.

Fig. 9 (a) shows envelopes extracted over time by measuring the same object at predetermined intervals by a frequency modulated continuous wave radar sensor. Referring to Fig. 9 (a), the overall waveforms of the envelopes are similar, but as can be seen in Fig. 9 (b), which is an enlarged portion of Fig. 9 (a), the peak size moves over time. As a reference, as can be seen in Fig. 9 (c), the peak frequency also moves over time.

Therefore, the memory 12 may extract and store a plurality of envelopes over time for the same object. Assuming that the state of the object changes over time, a plurality of envelopes over time may mean a plurality of envelopes depending on the state. That is, data that maps envelope waveforms by type of object stored in the memory 12 may include a plurality of envelope waveforms for each type of object according to the state of each object. For example, the memory 12 may store a plurality of envelope waveforms according to the state of the object corresponding to the first type, a plurality of envelope waveforms according to the state of the object corresponding to the second type, ..., a plurality of envelope waveforms according to the state of the object corresponding to the Nth type. Through this, the electronic device 10 can obtain characteristic information such as the current state as well as the type of the object.

Therefore, the controller 20 can obtain the characteristics of the object by using the intermediate frequency components extracted by the filter 109. More precisely, the controller 20 can obtain the characteristics of the object by using the envelopes of the intermediate frequency components extracted by the filter 109.

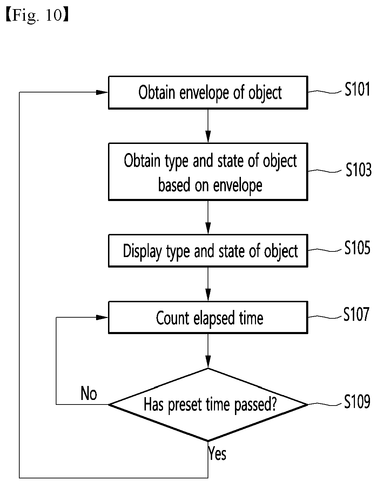

Fig. 10 is a flowchart illustrating an operation method of an electronic device according to an embodiment of the present disclosure.

The controller 20 can obtain an envelope of an object (S101).

The controller 20 can obtain an envelope of an object existing in a receiving part 11 through a frequency modulated continuous wave radar sensor 100.

The controller 20 can obtain the type and state of the object based on the envelope (S103).

The controller 20 can obtain the type and state of the object by detecting an envelope most similar to the data obtained from the data stored in the memory 12.

If data that only maps the envelope waveform for the type of object is stored in the memory 12, the controller 20 can obtain only the type of the object having a waveform similar to the envelope obtained by the extractor 111 in the memory 12.

The controller 20 can display the type and state of the obtained object on the display 14 (S105).

For example, the display 14 can display the type of the object existing in the receiving part 11 as 'apple' and the state as 'fresh'.

The controller 20 can display the type and state of each object received in the receiving part 11 on the display 14.

The controller 20 can count the elapsed time (S107).

The controller 20 can determine whether a preset time has elapsed (S109).

For example, the controller 20 can determine whether 24 hours have elapsed after displaying the type and state of the object. However, the set time here is only an example and may be changed by user input, etc.

When the preset time has elapsed, the controller 20 can obtain the object's envelope again, obtain the type and state, and display them on the display 14.

For example, the display 14 can display that the type of the object existing in the receiving part 11 is 'apple' and the state is 'rotten'.

Through this, the electronic device 10 has the advantage of being able to easily guide the user to the type and state of the object existing in the receiving part 11.

Meanwhile, as described above, the electronic device 10 can operate independently, but the electronic device 10 can also operate through communication with at least one of a server and a smartphone.

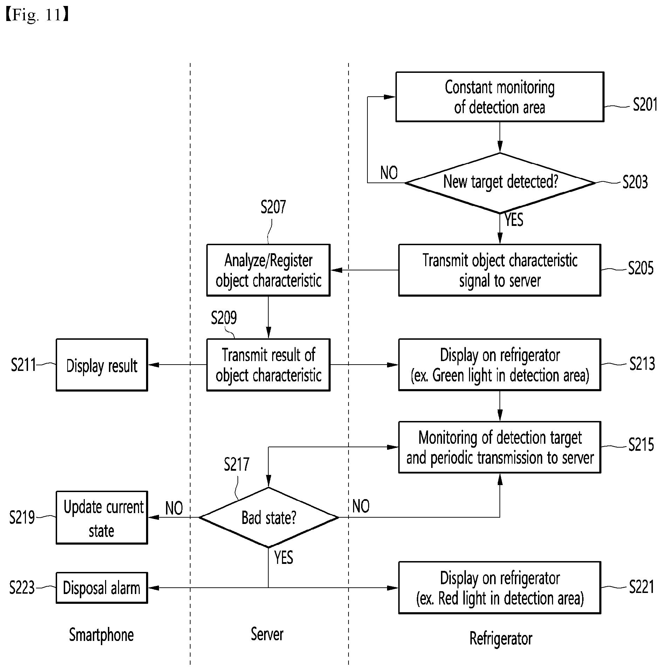

Fig. 11 is a flowchart illustrating a method in which an electronic device according to an embodiment of the present disclosure communicates with a server and a smartphone and operates.

The electronic device 10 can constantly monitor a detection area (S201).

That is, the electronic device 10 can sense a space S formed in the receiving part 11 in real time with a frequency modulated continuous wave radar sensor 100. Alternatively, the electronic device 10 can sense the space S formed in the receiving part 11 at preset intervals with a frequency modulated continuous wave radar sensor 100.

The electronic device 10 can determine whether a new target is detected (S203).

If a new target that did not exist before is detected, the controller 20 can sense the new target with the frequency modulated continuous wave radar sensor 100 to obtain an object characteristic signal and transmit it to the server (S205).

The server may store data that maps each type and state of an object to an envelope waveform.

Here, the object characteristic signal may include an envelope.

The server may analyze and register the object characteristic signal received from the electronic device 10 (S207).

The server can analyze the object characteristic signal by extracting the object characteristic signal, that is, the one whose envelope and waveform are most similar to those of a new object, from the data, and register the object for which the analysis is complete.

The server can transmit the analysis result of the object characteristic to at least one of the smartphone and the electronic device 10 (S209).

When the smartphone receives the analysis result of the object characteristic, it can display the received result (S211).

Similarly, when the electronic device 10 receives the analysis result of the object characteristic, it can display the result on the display 14. In addition, the electronic device 10 can adjust the lighting of the detection area to a first color (e.g., green) so that the user can be notified of the registration of a new target.

The electronic device 10 can monitor the detection target and periodically transmit the monitoring information to the server (S215).

The detection target can include not only the previously registered target but also a new target.

The server can periodically receive the monitoring information and update the state of the detection target accordingly.

The server can determine whether the state of the detection target is a bad state (S217).

The server can determine whether the detection target is in a bad state based on the state of the detection target obtained through the envelope.

If the state of the detection target is not in a bad state, the server can transmit the current state to the smartphone and the electronic device 10.

The smartphone can update the received current state, and the electronic device 10 can also display the current state, continuously monitor the detection target, and periodically transmit monitoring information to the server.

On the other hand, if the state of the detection target is determined to be in a bad state, the server can transmit information about the determined bad state to the smartphone and the electronic device 10.

The smartphone may output a disposal alarm when receiving information about a bad state (S223).

The electronic device 10 may display information about the bad state on the display 14 (S221).

In addition, the electronic device 10 may adjust the lighting of the detection area to a second color (e.g., red) so that the user may know that the state of the detection target is bad.

Meanwhile, in step S217, the server may determine whether the state of the detection target is optimal. The optimal state may indicate the best state for consuming food. When the server transmits information about the optimal state of the detection target to the smartphone and the electronic device 10, the smartphone may output an eating alarm. The electronic device 10 may adjust the lighting of the detection area to a third color (e.g., blue) so that the user may know that the state of the detection target is optimal.

Through this, the state of the object inside the electronic device 10 is managed in real time, so that information can be provided so that the object can be used before the state of the object becomes bad, and thus, there is an advantage of improving user convenience.

Meanwhile, although not shown in Fig. 11, the electronic device can obtain the location of each object by calculating the distance of each object through the frequency modulated continuous wave radar sensor 100. This electronic device can transmit the location information of the object to a smartphone and display the location information of the object on the smartphone.

Meanwhile, the electronic device 10 is assumed as a refrigerator and explained, but the frequency modulated continuous wave radar sensor 100 may be equipped to be applied to not only home appliances such as a styler (detecting clothing type and condition), a washing machine/dryer (detecting clothing condition (dryness)), an oven/cookware (detecting cooking condition), and healthcare (detecting biometric signals/information), but also to road conditions (icy, unpaved, standing rain, etc.) in automobile/industrial related devices, passenger and cargo classification, foreign substance detection, water level in a tank, material condition in a high temperature/high pressure chamber, drone collision prevention, screening station X-ray replacement, and fire rescue (biometric recognition).

Meanwhile, according to an embodiment, the frequency modulated continuous wave radar sensor 100 may further include a plurality of electromagnetic wave lenses (not shown). Specifically, the frequency modulated continuous wave radar sensor 100 may further include a first lens (not shown) for concentrating a signal transmitted through the transmitting antenna 103 onto an object, and a second lens (not shown) for concentrating a signal reflected from the object onto the receiving antenna 105. The first lens (not shown) may be installed at the front end of the transmitting antenna 103, and the second lens (not shown) may be installed at the front end of the receiving antenna 105.

In addition, according to an embodiment, the frequency modulated continuous wave radar sensor 100 may acquire the characteristics of the object while rotating the object. In this case, since the envelope is acquired together with the incident angle information, there is an advantage in that the characteristics of the object can be acquired more accurately by improving the error due to the incident angle.

The above description is merely an example of the technical idea of the present disclosure, and those with ordinary knowledge in the technical field to which the present disclosure belongs may make various modifications and variations without departing from the essential characteristics of the present disclosure.

Therefore, the embodiments disclosed in the present disclosure are not intended to limit the technical idea of the present disclosure but to explain it, and the scope of the technical idea of the present disclosure is not limited by these embodiments.

The protection scope of the present disclosure should be interpreted by the claims below, and all technical ideas within the equivalent scope should be interpreted as being included in the scope of the rights of the present disclosure.

## Claims

1. A frequency modulated continuous wave radar sensor, comprising:
a signal generator configured to generate a Frequency Modulated (FM) signal whose frequency changes over time;
a transmitting antenna configured to transmit the FM signal generated by the signal generator;
a receiving antenna configured to receive a reflected signal of an FM signal reflected from an object;
a frequency mixer configured to output a difference between the FM signal and the reflected signal; and
a filter configured to extract an intermediate frequency component from an output of the frequency mixer.

2. The frequency modulated continuous wave radar sensor of claim 1, further comprising an extractor configured to obtain an envelope of the extracted intermediate frequency component.

3. The frequency modulated continuous wave radar sensor of claim 2, wherein the extractor is configured to obtain the envelope by demodulating or Hilbert transforming the extracted intermediate frequency component.

4. An electronic device, comprising:
a receiving part in which a space for receiving an object is formed;
a frequency modulated continuous wave radar sensor configured to detect characteristics of the object; and
a controller,
wherein the frequency modulated continuous wave radar sensor comprises:
a signal generator configured to generate a Frequency Modulated (FM) signal whose frequency changes over time;
a transmitting antenna configured to transmit the FM signal generated by the signal generator;
a receiving antenna configured to receive a reflected signal of an FM signal reflected from an object;
a frequency mixer configured to output a difference between the FM signal and the reflected signal; and
a filter configured to extract an intermediate frequency component from an output of the frequency mixer,
wherein the controller is configured to acquire characteristics of the object using the extracted intermediate frequency component.

5. The electronic device of claim 4, wherein the frequency modulated continuous wave radar sensor further comprises an extractor configured to obtain an envelope of the extracted intermediate frequency component.

6. The electronic device of claim 5, wherein the extractor is configured to obtain the envelope by demodulating or Hilbert transforming the extracted intermediate frequency component.

7. The electronic device of claim 5, further comprising a memory configured to store data that maps envelope waveforms of each type of object,
wherein the controller is configured to obtain a type of object having a waveform similar to the envelope obtained by the extractor from the memory.

8. The electronic device of claim 7, further comprising a display configured to output the obtained object.

9. The electronic device of claim 7, wherein the data includes a plurality of envelope waveforms for each type of object according to state of each object.

10. The electronic device of claim 9, wherein the controller is configured to obtain a type and state of objects accommodated in the space.

11. An operating method of a frequency modulated continuous wave radar sensor, comprising:
generating a Frequency Modulated (FM) signal whose frequency changes over time;
transmitting the FM signal generated by a signal generator;
receiving a reflected signal in which the FM signal is reflected from an object;
outputting a difference between the FM signal and the reflected signal; and
extracting an intermediate frequency component from an output of the frequency mixer.

12. The operating method of a frequency modulated continuous wave radar sensor of claim 11, further comprising:
obtaining an envelope of the extracted intermediate frequency component.

13. An operating method of an electronic device, comprising:
generating a Frequency Modulated (FM) signal whose frequency changes over time;
transmitting the FM signal generated by a signal generator;
receiving a reflected signal in which the FM signal is reflected from an object;
outputting a difference between the FM signal and the reflected signal;
extracting an intermediate frequency component from an output of the frequency mixer; and
obtaining characteristics of the object using the extracted intermediate frequency component.

14. The operating method of an electronic device of claim 13, further comprising:
obtaining an envelope of the extracted intermediate frequency component, and
the obtaining of the characteristics of the object includes obtaining the characteristics of the object using the envelope.

15. The operating method of an electronic device of claim 13, further comprising:
displaying the characteristics of the object.
